Europäisches Patentamt

European Patent Office

Office européen des brevets

(11) Veröffentlichungsnummer: **0 327 846**

**A1**

# (12) EUROPÄISCHE PATENTANMELDUNG

(21) Anmeldenummer: **89100811.2**

(22) Anmeldetag: **18.01.89**

(51) Int. Cl.4: **H03F 3/72 , H03K 17/68**

(30) Priorität: **10.02.88 DE 3804068**

(43) Veröffentlichungstag der Anmeldung:
**16.08.89 Patentblatt 89/33**

(84) Benannte Vertragsstaaten:
**DE FR GB IT NL**

(71) Anmelder: **Siemens Aktiengesellschaft**
**Wittelsbacherplatz 2**
**D-8000 München 2(DE)**

(72) Erfinder: **Kriedt, Hans, Dipl.-Ing.**
**Triester Strasse 33**
**D-8000 München 80(DE)**
Erfinder: **Müller, Wladimir, Dipl.-Ing.**
**Teufelsgrabenweg 1**
**D-8155 Valley/Grub(DE)**

(54) **Schaltungsanordnung zum verzerrungsarmen Schalten von Signalen.**

(57) Ein mit einer Gegentaktendstufe (T1,T2) und einer Differenzverstärkerstufe (T3,T4) ausgestatteter, gegengekoppelter Minimaloperationsverstärker, der als Referenzpotential ein gegebenes Bezugspotential erhält, schließt Signale, die auf den Ausgang (A) des Operationsverstärkers gegeben werden, gegen das gegebene Bezugspotential kurz, wenn der durch die Stromquelle (Q) eingeprägte Ruhestrom der Differenzverstärkerstufe (T3,T4) zugeschaltet wird. Bei abgeschaltetem Ruhestrom der Differenzverstärkerstufe (T3,T4) übt durch das Sperren der Transistoren der Gegentaktendstufe (T1,T2) der Operationsverstärker keinen Einfluß auf das Signal aus.

FIG 1

EP 0 327 846 A1

## Schaltungsanordnung zum verzerrungsarmen Schalten von Signalen

Die Erfindung bezieht sich auf eine Schaltungsanordnung zum verzerrungsarmen Schalten von Signalen nach dem Oberbegriff des Anspruchs 1.

Es ist bekannt, mit einem Operationsverstärker mit Gegentaktendstufe und mit einer schaltbaren Ruhestromquelle für eine Differenzverstärkerstufe des Operationsverstärkers Signale, die am Eingang des Operationsverstärkers liegen, auf dessen Ausgang durchzuschalten, indem durch Ein- oder Ausschalten des Ruhestroms der Differenzverstärkerstufe des Operationsverstärkers die Gesamtverstärkung auf einen gegebenen Wert oder den Wert Null gesetzt wird (zum Beispiel: Integrated Circuit Linear Databook, RCA, 1976, S. 200).

Dabei ist es allerdings nötig, das zu schaltende Signal durch den Operationsverstärker zu leiten, was zu Verzerrungen des zu schaltenden Signals durch den Operationsverstärker führt. Eine Verminderung der durch den Operationsverstärker hervorgerufenen Verzerrungen bedingt einen erhöhten Schaltungsaufwand.

Der Erfindung liegt die Aufgabe zugrunde, ein Signal mit einem steuerbaren Halbleiterschalter mit geringem Aufwand verzerrungsarm zu schalten.

Die Aufgabe wird bei einer gattungsgemäßen Schaltungsanordnung durch die kennzeichnenden Merkmale des Anspruches 1 gelöst.

Weiterbildungen der Erfindung sind Gegenstand von Unteransprüchen.

Die Erfindung bringt den Vorteil eines geringen schaltungstechnischen Aufwandes mit sich, da der Einfluß des Operations verstärkers auf die Signalform durch den Betrieb als Kurzschlußschalter gering gehalten wird. Maßnahmen zur Verbesserung der Übertragungseigenschaften sind, da das zu schaltende Signal entgegen üblicher Praxis nicht durch den Operationsverstärker geführt wird, sondern an dessen Ausgang anliegt, nicht notwendig, wodurch es bei der Realisierung des Operationsverstärkers lediglich einfachster Ausführungsformen bedarf.

Die Erfindung wird nachfolgend anhand von den in den FIG der Zeichnung dargestellten Ausführungsbeispielen näher erläutert. Es zeigen:

FIG 1 ein Schaltbild einer ersten Ausführungsform einer obengenannten Schaltungsanordnung,

FIG 2 ein Schaltbild einer zweiten Ausführungsform einer obengenannten Schaltungsanordnung.

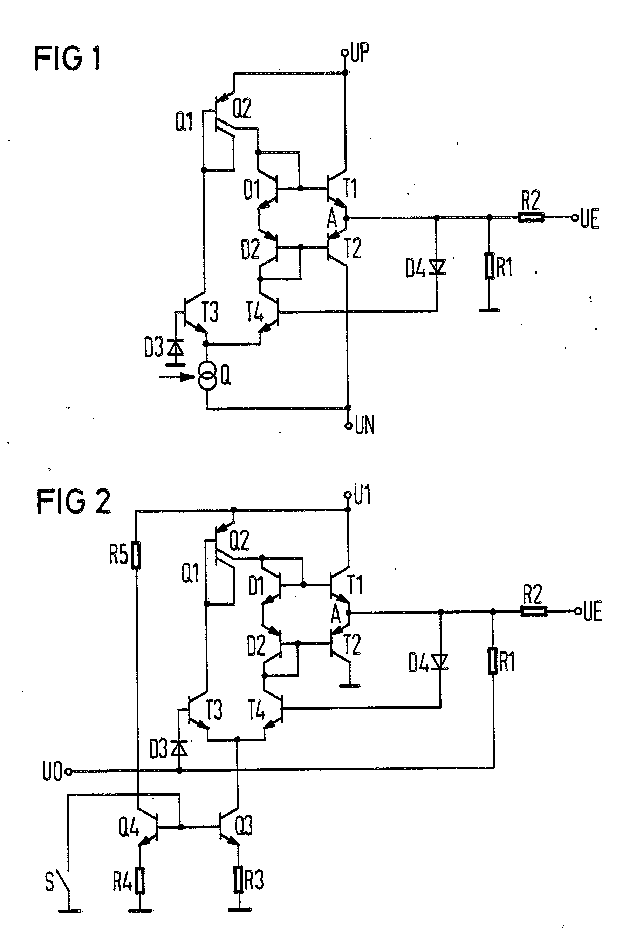

In FIG 1 ist das Schaltbild eines mit geringem schaltungstechnischem Aufwand aufgebauten Operationsverstärkers dargestellt. Der Operationsverstärker setzt sich im wesentlichen aus einer Gegentaktendstufe T1,T2, einer Differenzverstärkerstufe T3,T4, einer Stromquelle Q und einem Stromspiegel Q1,Q2 zusammen. Die Gegentaktendstufe ist als komplementärer Emitterfolger mit einem npn-Transistor T1 und einem pnp-Transistor T2 ausgeführt. Die Basisanschlüsse beider Transistoren sind zur Arbeitspunkteinstellung durch zwei in Reihe geschaltete und in Durchlaßrichtung gepolte Dioden D1,D2 miteinander verbunden. Die Differenzverstärkerstufe besteht aus zwei npn-Transistoren T3,T4, deren Emitteranschlüsse zusammengeführt und über eine Stromquelle Q mit dem negativen Betriebspotential UN verbunden sind. Ein Transistor T3 der Differenzverstärkerstufe liegt über eine in Durchlaßrichtung gepolte Diode D3 mit dem Basisanschluß auf Bezugspotential. Der Kollektoranschluß des Transistors T3 ist über den Eingangsstromkreis Q1 eines Stromspiegels mit dem positiven Betriebspotential UP verbunden. Der Ausgangsstromkreis Q2 des Stromspiegels Q1,Q2 ist an den Basisanschluß des Transistors T1 gekoppelt. Die Gegenkopplung des Operationsverstärkers erfolgt über eine in Durchlaßrichtung gepolte Diode D4 von den zusammengeführten Emitteranschlüssen der Endstufentransistoren, im folgenden Ausgang A des Operationsverstärkers genannt, an den Basisanschluß des zweiten Transistors T4 der Differenzverstärkerstufe. Die Beschaltung der Eingänge des Operationsverstärkers, in diesem Fall durch die Basisanschlüsse der Transistoren T3 und T4 gegeben, mit Dioden D3,D4 bringt im wesentlichen den Vorteil mit sich, daß unzulässige Potentialdifferenzen an den Eingängen unterbunden werden. Der Kollektoranschluß des Transistors T4 ist mit dem Basisanschluß des Transistors T2 direkt verbunden. Das zu schaltende Signal wird über einen Widerstand R2 auf den Ausgang des Operationsverstärkers geführt, der über einen zweiten Widerstand R1 auf Bezugspotential liegt. Der Vorteil einer derartigen Beschaltung liegt zum einen darin, daß der Durchgangswiderstand der Schaltungsanordnung in beiden Betriebsfällen einen definierten Wert annimmt und zum anderen darin, daß bei geeigneter Dimensionierung des Widerstandes R2 die Endstufentransistoren T1,T2 des Operationsverstärkers im Kurzschlußbetrieb vor Überlastung geschützt werden. Im vorliegenden Fall wurde als Bezugspotential Masse gewählt, was beispielsweise vorteilhaft ist in Verbindung mit elektrischen Schaltungen, die mit einer symmetrischen Spannungsversorgung betrieben werden und deren Bezugspotential, nämlich Masse, damit festliegt.

Die in FIG 2 dargestellte Schaltungsanordnung geht aus der in FIG 1 gezeigten hervor. Als Unterschied ist jedoch festzuhalten, daß das negative Betriebspotential auf Masse und das Bezugspotential der Schaltung auf einem gegebenen Wert UO zwischen Masse und positivem Betriebspotential liegt. Darüber hinaus wurde die Stromquelle für den Ruhestrom der Differenzverstärkerstufe durch folgende Schaltungsanordnung realisiert: Ein zu einer Diode verschalteter npn-Transistor Q4 liegt mit seinem Emitteranschluß über einen Widerstand R4 an Masse und mit seinem Kollektoranschluß über einen weiteren Widerstand R5 auf positivem Betriebspotential. Der Kollektoranschluß des Transistors Q4 ist mit der Basis eines zweiten Transistors Q3 direkt verbunden. Der Emitteranschluß des Transistors Q3 liegt wiederum über einen Widerstand R3 auf Masse. Die Emitteranschlüsse der beiden Transistoren der Differenzverstärkerstufe sind direkt mit dem Kollektoranschluß des Transistors Q3 verbunden. Durch Umlegen eines Schalters S wird der Kollektoranschluß des Transistors Q4 gegen Masse kurzgeschlossen und dadurch die Konstantstromquelle abgeschaltet.

In beiden Ausführungsbeispielen ist die Gegenkopplung so gewählt, daß die Verstärkung eins ist. Das ist insbesondere deshalb von Vorteil, da im Sinne einer einfachen Realisierbarkeit kein zusätzlicher Schaltungsaufwand nötig ist.

Nachdem der prinzipielle Aufbau der in der Zeichnung dargestellten Schaltungsanordnung erläutert worden ist, wird nunmehr auf die Arbeitsweise dieser Schaltungsanordnung näher eingegangen.

Bei abgeschalteter Ruhestromquelle Q wird der zur Arbeitspunkteinstellung der Gegentaktendstufe notwendige Strom, der durch den Transistor T4, die Dioden D1 und D2 und den Stromspiegel fließt, gleich null. Dadurch sperren die Endstufentransistoren und der Ausgang des Operationsverstärkers geht über in einen hochohmigen Zustand gegenüber den beiden Betriebspotentialen und dem Bezugspotential. Damit ergibt sich als Wert für den Durchgangswiderstand zwischen Signaleingang UE und Bezugspotential die Summe der Werte der beiden Widerstände R1 und R2.

Bei eingeschalteter Stromquelle Q regelt der Operationsverstärker seinen Ausgang so ein, daß an den Basisanschlüssen der beiden Transistoren der Differenzverstärkerstufe gleiches Potential liegt. Da der Basisanschluß des Transistors T3 über die Diode D3 auf Bezugspotential liegt, stellt sich am Ausgang des Operationsverstärkers, der über die Diode D4 mit dem Basisanschluß des Transistors T4 verbunden ist, ebenfalls das Bezugspotential ein. Der Durchgangswiderstand zwischen Signaleingang UE und Bezugspotential ist damit durch den Widerstand R2 gegeben. Der Potentialausgleich am Ausgang des Operationsverstärkers erfolgt dadurch, daß bei positiver Halbwelle des Eingangssignales der Transistor T2 und bei negativer Halbwelle der Transistor T1 stärker leitend wird.

Abschließend sei noch bemerkt, daß ein Betrieb der Schaltungsanordnung mit entgegengesetzter Polarität ermöglicht wird, indem pnp- durch npn-Transistoren und npn- durch pnp-Transistoren ersetzt werden. Darüber hinaus bleibt der Aufbau des Operationsverstärkers nicht nur auf bipolare Transistoren beschränkt, sondern ist auch mit CMOS-Transistoren realisierbar. Der ohnehin geringe Leistungsbedarf der gezeigten Schaltungsanordnung wird dadurch weiter vermindert.

## Ansprüche

1. Schaltungsanordnung zum verzerrungsarmen Schalten von Signalen gegen ein gegebenes Bezugspotential mit einem Operationsverstärker mit Gegentaktendstufe (T1,T2) und mit einer schaltbaren Ruhestromquelle (Q) für eine Differenzverstärkerstufe (T3,T4) des Operationsverstärkers, **dadurch gekennzeichnet,** daß der Operationsverstärker gegengekoppelt ist, daß das Bezugspotential das Referenzpotential des Operationsverstärkers ist und daß die Endpunkte der zu schaltenden Strecke durch den Ausgang (A) des Operationsverstärkers und das Bezugspotential gegeben sind.

2. Schaltungsanordnung nach Anspruch 1, **dadurch gekennzeichnet,** daß die Gegenkopplung derart gewählt ist, daß die Gesamtverstärkung eins ist.

3. Schaltungsanordnung nach mindestens einem der Ansprüche 1 und 2, **dadurch gekennzeichnet,** daß der Ausgang (A) des Operationsverstärkers durch einen Widerstand (R1) mit dem gegebenen Bezugspotential verbunden ist.

4. Schaltungsanordnung nach mindestens einem der Ansprüche 1 bis 3, **dadurch gekennzeichnet,** daß das Signal über einen Widerstand (R2) an den Ausgang (A) des Operationsverstärkers geführt wird.

5. Schaltungsanordnung nach mindestens einem der Ansprüche 1 bis 4, **dadurch gekennzeichnet,** daß das gegebene Bezugspotential Masse ist.

6. Schaltungsanordnung nach mindestens einem der Ansprüche 1 bis 5, **dadurch gekennzeichnet,** daß die Eingänge der Differenzverstärkerstufe (T3,T4) mit Dioden (D3,D4) beschaltet sind.

# FIG 1

# FIG 2

# EUROPÄISCHER RECHERCHENBERICHT

Nummer der Anmeldung

EP 89 10 0811

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | NUCLEAR INSTRUMENTS AND METHODS, Band 80, Nr. 1, 1. April 1970, Seiten 172-174, North-Holland Publishing CO., NL; A. BATTISTA: "A simple, high performance linear gate for nuclear physics applications" * Figuren 1,3,4; Seiten 172,173 * | 1-5 | H 03 F 3/72 H 03 K 17/68 |
| A | EP-A-0 025 950 (TOKYO SHIBAURA DENKI) * Figuren 1,3; Zusammenfassung; Seite 6, Zeile 17 - Seite 7, Zeile 26 * | 1-4 | |
| A | DE-A-3 221 852 (TOKYO SHIBAURA DENKI K.K.) * Figuren 1-8,12,14; Seite 14, Zeilen 6-18 * | 1-3,5 | |
| A | DE-A-3 018 556 (MITSUBISHI DENKI K.K.) * Figuren 3,5; Seite 8, Zeile 9 - Seite 9, Zeile 23 * | 1 | |

RECHERCHIERTE SACHGEBIETE (Int. Cl.4)

H 03 F
H 03 K

Der vorliegende Recherchenbericht wurde für alle Patentansprüche erstellt

| Recherchenort | Abschlußdatum der Recherche | Prüfer |
|---|---|---|
| DEN HAAG | 18-05-1989 | TYBERGHIEN G.M.P. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
.....................................................................
& : Mitglied der gleichen Patentfamilie, übereinstimmendes Dokument